# EUROPEAN PATENT SPECIFICATION

(11) **EP 0 546 280 B1**
(45) Date of publication and mention of the grant of the patent: **10.01.1996**
(21) Application number: 92117636.8
(22) Date of filing: 15.10.1992
(51) Int. Cl.: B01J 4/00, F17C 13/04

(54) **Gas delivery panels**
Gaslieferungstafeln
Tableaux de livraison de gaz

(30) Priority: 26.11.1991 US 798580
(43) Date of publication of application: 16.06.1993
(73) Proprietor: PRAXAIR TECHNOLOGY, INC., Danbury, CT 06810-5113 (US)
(72) Inventor: Gregoire, Roger Joseph, San Antonio 78247, Texas (US)
(74) Representative: Schwan, Gerhard, Dipl.-Ing.

(56) References cited:
- GB-A- 2 176 270
- US-A- 4 887 645
- US-A- 4 971 100

## Description

### Background of the Invention

Field of the Invention - The invention relates to gas panels for supplying high purity process gas to a point-of-use location. More particularly, it relates to an improved gas panel having enhanced reliability and reduced potential of gas contamination.

Description of the Prior Art - In the semiconductor manufacturing industry and in various other industrial operations, gas cabinets are used to deliver high purity process gases to a point-of-use location, commonly referred to as a tool location. Such cabinets contain high purity gas supply cylinders and gas panels for delivering gases to the tool location.

For high purity gas operations, it is essential that the process gases be delivered to the tool location with minimum contamination since even parts-per-million impurity levels can adversely affect the efficiency of semiconductor and other high purity products. In addition, it is necessary to assure that the gas panels are capable of operating safely and without gas leakage that could jeopardize the health and safety of gas cabinet operators.

Gas panels are thus required to deliver gases at desired pressure levels while maintaining gas purity and maintaining safety integrity. The panels must also provide for purge functions to enable gas cylinder changes to be performed safely and without gas contamination. For such purposes, typical gas panels consist of specialized valves, components, interconnecting piping and associated hardware, with high purity, hazardous cylinders of gas being attached to the inlet to the gas panel, and the outlet thereof, attaching through a suitable pipeline to a process reactor.

A variety of gas panel arrangements have been proposed in the art to satisfy the various requirements for high purity process gas operations. In a representative gas panel, a flow limiting valve, an emergency shutoff valve, a gas regulator with high and low side gauges, and four manual valves are employed. A manual purge valve connects the nitrogen supply employed therein, and a manual process valve connects to the user system. Two vent valves connect the high and low side of the panel to vent means, including a vacuum generator module. The vacuum module contains an eductor driven by a nitrogen or other inert gas supply and exhausting to a vent stack system. A low side safety relief port connection to the vent stack is provided.

Despite such panel arrangements known in the art, there remains a genuine need for further gas panel improvements to meet the need for very high, or ultrahigh purity, gases to satisfy the ever increasing requirements of advanced process technologies for the semiconductor and other high technology industries. Such improvements must take into account that a large number of desired process gases are considered of a hazardous nature, i.e. are very toxic, corrosive or flammable, for example. The improvements desired in the art thus need to minimize contamination within the gas delivery panel and achieve enhanced control and handling of hazardous process gases.

It is an object of the invention, therefore, to provide an improved gas delivery panel.

It is another object of the invention to provide a gas panel capable of minimizing contamination of high purity process gases being delivered to a tool location.

It is a further object of the invention to provide an improved gas panel capable of enhancing the reliability and safety of high purity gas delivery operations.

With these and other objects in mind, the invention is hereinafter described in detail, the novel features thereof being particularly pointed out in the appended claims.

### Summary of the Invention

The invention comprises a gas panel of reduced size with an advantageous arrangement of specialized valves, pressure regulators and associated connections that serve to enhance gas supply purity and safety.

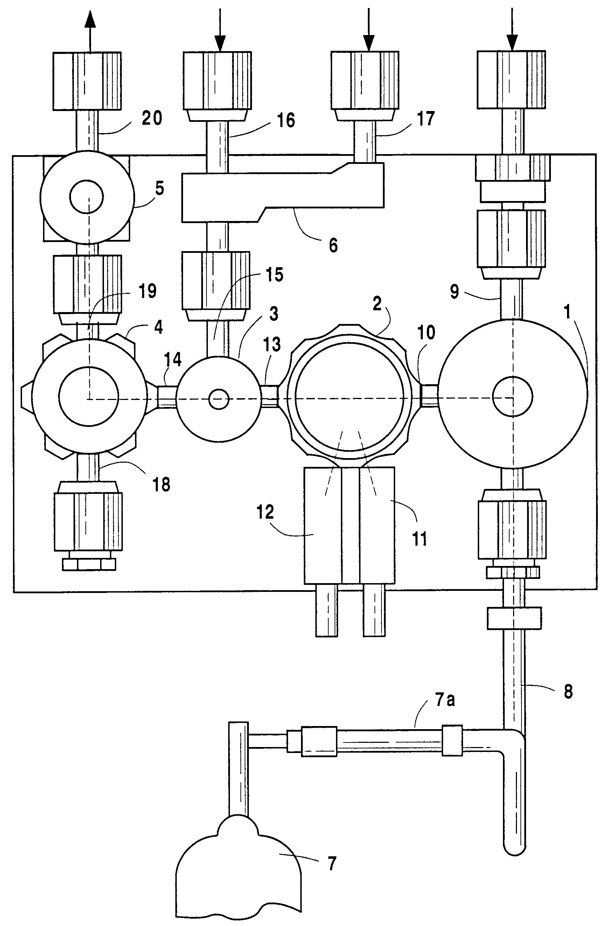

### Brief Description of the Drawing

The invention is hereinafter described in detail with reference to the accompanying single figure drawing illustrating the gas flow sequence of a typical embodiment of the gas delivery panels of the invention.

### Detailed Description of the Invention

The objects of the invention are accomplished by a reduced size, micropanel arrangement adapted to handle the unique problems associated with the control of ultra high purity hazardous gases. The reduced size and simplified flow arrangement of the invention reduces gas surface area, gas connections, and stagnant gas pockets, so as to reduce particulate or other contamination of process gas. It also reduces leak potential and provides for low pressure venting to increase system reliability and safety. The minimizing or elimination of contamination within the gas delivery panel is of critical importance to semiconductor and other advanced gas processing. The improved safety aspects of the invention are likewise a necessary part of the development of gas panels to satisfy the industrial requirements of advanced and future high purity gas processing operations.

The gas purity benefits of the micropanel of the invention, as contrasted to prior purge panel systems, are that (1) particle generation is reduced, because of the use of fewer components and moving parts and less wetted surface area; (2) particle entrapment areas are reduced, with a flow through configuration resulting in no appreciable dead leg areas, and the simplified design, with fewer components, mechanical connections and welds, further contributing to a desirable reduction in particle entrapment areas, and (3) gaseous contamination is minimized because of fewer leak potential areas being present, less wetted surface area being used, and fewer voids and entrapment areas existing, thereby enabling better and more complete purges to be carried out. The safety benefits of the micropanel configuration of the invention, compared to prior purge panel systems are that (1) the leak potential of the system is reduced because less mechanical connections, less seals to the atmosphere and less welds are employed; (2) the reliability of the gas panel system is enhanced because fewer components are employed and a simplified gas delivery operation is practiced; and (3) controlled low pressure venting is employed, which prevents accidental high pressure release of process gas.

With reference to the drawing, it will be appreciated that the gas delivery panel illustrated therein is the gas panel for one process gas, such as, for example, silane. In the overall practice of the invention, one or more, e.g. three, such gas delivery panels may be employed, with each panel being connected to a separate process gas cylinder for the delivery of process gas as desired for any particular semiconductor or other operation requiring the use of one or more ultrahigh purity process gases. The micropanel of the illustrated embodiment of the invention contains a purge gas valve, a pressure regulator, vent valve, test valve, process gas valve and vacuum generator module. The panel components are arranged and ported so that the gas flow path is preferably straight flow through, with minimum bends and stagnant gas pockets. For purposes of this invention, straight flow through gas passage will be understood to comprise a continuous flow path essentially without stagnant gas pockets or dead flow legs, for example, on either side of the pressure regulator. The micropanel components are arranged such that the fluid passage parts therein are aligned essentially in the same plane, on both sides of the pressure regulator, to provide such straight flow through gas passage in preferred embodiments of the invention. The flow passages on the downstream side of the pressure regulator are commonly the same size as on the upstream side thereof, e.g. the 0.635 cm (1/4") industry standard, although it is also within the scope of the invention to employ flow passages of different sizes. As indicated above, this arrangement reduces undesirable particle contamination of the process gas flowing through the panel and maintains ultrahigh gas purity of the process gas being delivered from the process gas cylinder to the tool location.

In the embodiment of the drawing, the numeral 1 represents the purge gas valve, with pressure regulator 2, vent valve 3 and test valve 4 being arranged for preferred straight flow through gas passage. From test valve 4, process gas or nitrogen or other inert purge gas flows to process valve 5 for delivery to the tool location. From vent valve 3, purge gas flows through vacuum module 6 for venting from the gas panel.

Purge gas valve 1 has ports arranged so that, when said valve is closed, ports are open at the six and nine o'clock positions, whereas, when said valve is open, ports are open at the six, nine and twelve o'clock positions. Thus, when purge gas valve 1 is closed, process gas from a process gas supply cylinder connected to the panel passes to purge gas valve 1 for flow to pressure regulator 2, vent valve 3 and test valve 4. When, on the other hand, purge gas valve 1 is open, purge gas from a purge gas supply line passes to said purge gas valve for passage into the system, including the supply line from the process gas supply cylinder. In this regard, it should be noted that the process gas supply cylinder contains a valve that can be operated to control the passage of process gas to the system.

Pressure regulator 2 has flow through ports at three and nine o'clock positions, with transducer takeoffs at about five and seven o'clock positions. Thus, process gas or purge gas flows straight through pressure regulator 2, wherein the pressure is regulated from the higher process gas cylinder pressure to a desired lower pressure level for passage to the tool location or to the vent.

Vent valve 3 is located on the low pressure, downstream side only of pressure regulator 2, unlike particular prior art arrangements in which vent means are provided both upstream and downstream of the pressure regulator. Vent valve 3 has ports arranged so that, when said valve is closed, flow through open ports are permitted at the three and nine o'clock positions. When vent valve 3 is in an open position, a port at the twelve o'clock position is also open. Thus, when vent valve 3 is closed, process gas from pressure regulator 2 can flow straight through to test valve 4. When, on the other hand, vent valve 3 is open, process gas or purge gas can be passed separately from vent valve 3 to the vent stack system at low pressure as determined by the vacuum generator module.

Test valve 4, an optional but desirable feature of the invention and advantageously incorporated therein, as in the preferred straight flow through gas flow path in the gas panel, illustrated in the drawing, has ports arranged so that, when said valve is closed, ports are open at the three and twelve o'clock positions. When said valve is open, however, ports ore open at the three, six and twelve o'clock positions. Thus, when test valve 4 is closed, process gas is passed to process valve 5. When test valve 4 is open, a portion of said process gas can be passed from the gas flow panel for testing. Test valve 4 can also desirably be used for other purposes, as for purging during system fabrication and for pressurization during external helium spray leak tests of the system. Thus, gas can be passed to or from the panel when the said test valve means is in its open position.

Process flow valve 5 has ports arranged in the six and twelve o'clock positions to control the flow of process gas to the tool location. When said process flow valve is open, the desired flow of process gas is accomplished, with said flow of process gas to the tool location being terminated when said process flow valve 5 is closed.

Vacuum generator module 6, which connects to the low pressure vent valve 3 when said valve is in the open position, utilizes a nitrogen or other inert gas supply and a conventional eductor to generate a vacuum, i.e. subatmospheric pressure, which is used in particular embodiments of the invention to facilitate the evacuation of gas from the gas panel, thereby exhausting the vacuum gas and the gas evacuated from the vent valve means in the panel to a vent stack system.

In the operation of the gas panel of the invention, preferably in the straight flow through embodiments thereof, process gas from cylinder 7 containing flow valve 7a passes in line 8 to purge gas valve 1, with or without the passage of purge gas thereto in line 9 from a source of purge gas supply, not shown. Gas passes from said purge gas valve 1 through line 10 to pressure regulator 2 for desired control of the process and purge gas pressure in the panel. High pressure transducer takeoff 11 is desirably positioned at the five o'clock position, and low pressure transducer takeoff 12 is desirably positioned at the seven o'clock position, for appropriate pressure use for control or display purposes.

From pressure regulator 2, gas passes in line 13 to vent valve 3, in which process gas passes desirably with straight flow through for passage in line 14 to test valve 4. Gas being vented is passed in line 15 to vacuum generator module 6, from which gas being vented is passed to a suitable stack system through line 16. Purge gas is passed from a source of purge gas supply, not shown, through line 17 to said vacuum generator module 6. Gas to be withdrawn from the gas panel for testing purposes passes from test valve 4 through line 18, while gas being passed to the tool location is passed from said test valve 4 in line 19 to process valve 5.

The low pressure side only vent arrangement of the invention allows safe and effective gas release from the gas panel. The high pressure side purge gas provides the necessary purge gas for the entire gas panel system. The panel provides the necessary components to connect the process gas cylinder to the process at the tool location and supply ultra clean and difficult to handle process gas supply in a simplified, convenient and advantageous manner. The micropanel arrangement of the invention allows desirable direct straight flow through passage of process gas from the process gas cylinder to the tool location. The test valve 4 arrangement allows system checkout without any compromise of system integrity. When a process gas cylinder is exhausted, the gas panel can be vented and purged, the cylinder can be changed, and the panel can be purged, tested and placed back in use to conveniently supply the desired process gas to the tool location.

Those skilled in the art will appreciate that various changes and modifications can be made in the details of the invention as described herein without departing from the scope of the invention as recited in the appended claims. While various commercially available seal means can be used in the practice of the invention, for example, Cajon VCR® or Parker Vacuseal® face seal fittings are commonly employed as the sealing means for the various components of the micropanel of the invention. Likewise, commercially available valves, such as Nupro valves, can be utilized in the practice of the invention. Similarly, commercially available pressure regulators and vacuum generator modules can be employed in the gas panels of the invention, e.g. Tescom pressure regulators or Span vacuum generator modules. Those skilled in the art will appreciate that the various components of the gas panel, such as the purge gas valve, pressure regulator, vent valve and test valve are provided with their fluid passage ports aligned so as to facilitate the straight flow through gas flow operation of the preferred embodiments of the invention.

While vacuum generator module 6 is employed in the illustrative embodiment shown in the drawing, it is within the scope of the invention to employ high pressure purge gas instead of a vacuum generator to facilitate the evacuation of gas being vented through the vent valve means. Thus, purge gas can be supplied at pressures typically in the range of 20.68 to 34.47 bar (300 to 500 psig) or higher, while vacuum generators are commonly employed to generate a vacuum typically of 0.74 to 0.91 bar (22"-27" of mercury).

In the operation of the gas delivery panels of the invention, using either a vacuum generator or said high pressure purge, the purge operation essentially comprises pre- and post-cylinder change purge, as well as process gas purge, upon change-over from one process gas supply cylinder to another.

It will be understood that the materials of construction used in the invention are such as to be compatible with the process gases being employed, with stainless steel, e.g. 316L, being an industry standard. The purge gas employed will be nitrogen, argon or other inert gas that is non-toxic and non-reactive in the gas panel system.

It is within the scope of the invention to practice the invention in another desirable embodiment adapted to further minimize flow path surface area, gas connections, stagnant gas pockets, dead flow legs and the like. Thus, a single or unitary block of metal, e.g. stainless steel, or of other suitable material compatible with the gases being processed, can be machined to provide fluid passage ports for the interconnection of the valves and pressure regulator components necessary to carry out the low pressure only venting gas flow arrangement of the invention. The unitary metal block is adapted for the insertion therein of the purge gas valve means, pressure regulator means, vent valve means and process valve means for operation as described above, particularly in the preferred straight flow through gas passage embodiment of the invention. By the miniaturization of the unitary metal block and the associated components described above, including test valve means if so desired, it will be appreciated that the overall size of the gas delivery panel can be very appreciably reduced, with the gas flow paths of the system further minimized, and with the leak potential of the system likewise being further reduced, beyond that achieved in the embodiments of the micropanel of the invention as described above. The microblock version of the invention will thus be seen as a further, highly advantageous advance in the gas delivery panel art.

As indicated above, a gas cabinet for practical commercial operations may comprise more than one gas cylinder, e.g. three cylinders, each connected to a gas panel for the delivery of a particular gas to the tool location. For example, one cylinder may contain argon, oxygen, helium or nitrogen, another may contain freon, nitrous oxide or sulfur hexafluoride, for example, and a third may contain ammonia, chlorine, dichlorosilane, hydrogen, hydrogen chloride, silane or silicon tetrachloride.

The micropanel embodiments of the invention, including the microblock version thereof, represent a significant advance in the art, enhancing gas supply purity and the safety of its delivery from process gas supply cylinders to a tool location. The simplified gas panels of the invention reduce leak potential and enable low pressure venting so as to increase the reliability and safety characteristics of the gas panel. By reducing gas surface area and gas connections, and minimizing stagnant gas pockets, the high purity of the gas being supplied from gas cylinders is advantageously preserved at the high purity level necessary to satisfy the ever-increasing requirements of the semiconductor and other industries for high purity gas supply.

## Claims

1. A gas delivery panel for delivering high purity process gas from a supply cylinder (7) to a tool location comprising;
(a) purge gas valve means (1) adapted for operation between a closed position in which fluid passage ports are open for the passage of high purity process gas from a process gas supply cylinder (7) through said purge gas valve means, and an open position in which fluid passage ports are open for said passage of high purity process gas therethrough and for the passage therethrough of purge gas from a purge gas supply line;
(b) pressure regulator means (2) having flow passage ports for the passage of gas from said purge gas valve means (1) therethrough, said pressure regulator means being adapted to regulate the pressure of gases passing therethrough;
(c) vent valve means (3) positioned only on the low pressure side of said pressure regulator means (2) and adapted for operation between a closed position in which fluid passage ports are open for the passage of high purity process gas or purge gas from said pressure regulator means (2), and an open position in which fluid passage ports are open for said passage of process gas or purge gas, and for the separate passage of said gas therefrom for venting; and
(d) process flow valve means (5) adapted for operation between an open position in which fluid passage ports are open for the passage of high purity process gas or purge gas therethrough for delivery to a tool location, and a closed position in which said passage of gas is terminated.

2. The gas delivery panel of Claim 1 in which the fluid passage ports of said valve means (1, 3) on both sides of said pressure regulator means (2) are aligned essentially in the same plane to provide straight flow through gas passage therein.

3. The gas delivery panel of Claim 1 in which said purge gas valve means (1), in its closed position, has open fluid passage ports in the six and nine o'clock positions for the passage of process gas therethrough, and, in its open position, has open fluid passage ports in the six, nine and twelve o'clock positions for the passage of purge gas therethrough.

4. The gas delivery panel of Claim 1 in which said pressure regulator means (2) has high pressure transducer means (11) and low pressure transducer means (12) positioned thereon.

5. The gas delivery panel of Claim 4 in which said high pressure transducer means (11) is positioned at the five o'clock position and said low pressure transducer means (12) is positioned at the seven o'clock position.

6. The gas delivery panel of Claim 1 in which said vent valve means (3), in its closed position, has open fluid passage ports at the three and nine o'clock positions for the passage of process gas or purge gas therethrough to test valve means (4) and, in its open position, has open fluid passage ports at the three, nine and twelve o'clock positions for the passage of process gas or purge gas also for venting.

7. The gas delivery panel of Claim 1 in which said process flow valve means (5), in its open position, has open fluid passage ports for the passage of process gas or purge gas to the tool location, and, in its closed position, being adapted to preclude such passage of gas to the tool location.

8. The gas delivery panel of Claim 1 including vacuum generator means (6) adapted for the generation of a vacuum to facilitate the evacuation of gas passing from said vent valve means (3) when said vent valve means is in an open position for venting.

9. The gas delivery panel of Claim 8 in which said vacuum generator means (6) comprises an eductor, and an inert gas supply means thereto for the generation of a subatmospheric pressure, and including a vent stack system for the low pressure venting of vacuum gas and gas evacuated from said vent valve means.

10. The gas delivery panel of any one the the preceding claims and including conduit means (8) for establishing fluid communication between said purge gas valve means (1) and a process gas cylinder (7).

11. The gas delivery panel of claim 10 and including conduit means (20) for establishing fluid communication between said process flow valve means (5) and said tool location.

12. The gas delivery panel of any one of the preceding claims and including a unitary block of material adapted for the insertion of said purge gas valve means (1), pressure regulator means (2), vent valve means (3) and process valve means (5), said unitary block being adapted to provide fluid passage ports for the interconnection of said valve and pressure regulator means therein.

13. The gas delivery panel of claim 12 in which said unitary block and valve and pressure regulator means (1 to 5) are miniaturized to further simplify gas flow paths, reduce the potential for leaks and provide for low pressure venting, thereby further enhancing gas panel system reliability and safety.

14. The gas delivery panel of any one of the preceding claims and including test valve means (4) adapated for operation between a closed position in which fluid passage ports are open for the passage of process gas or purge gas to said process flow valve means (5), and an open position in which gas can also be passed to or from gas supply or receiving means outside said panel.

15. The gas delivery panel of claim 14 in which said test valve means (4), in its closed position, has open fluid passage ports at the three and twelve o'clock positions for the passage of process gas or purge gas to said process valve means, and, in its open position, also has an open fluid passage port at the six o'clock position for the separate passage of gas to or from said panel.

16. The gas delivery panel of claim 14 or 15 in which said test valve means (4) is positioned with the fluid passage ports thereof, and the fluid passage ports of the other valve means on both sides of said pressure regulator means, being aligned in essentially the same plane to provide straight flow through gas passage therein.

17. The gas delivery panel of any one of claims 12 to 16 in which the fluid passage ports of said valve means (1, 3) on both sides of said pressure regulator means (2) are aligned essentially in the same plane to provide straight flow through gas passage therein.

18. The gas delivery panel of any one of claims 12 to 17 in which said unitary block of material comprises a metal block.

19. The gas delivery panel of claim 18 in which said unitary block comprises a stainless steel block.

## Patentansprüche

1. Gaszufuhrkonsole zur Zufuhr von hochreinem Prozeßgas aus einer Versorgungsflasche (7) zu einer Verwendungsstelle mit
(a) einer Spülgas-Ventilanordnung (1) zum Umschalten zwischen einer Schließstellung, in welcher Fluiddurchlässe offen sind, um einen Durchstrom von hochreinem Prozeßgas aus einer Prozeßgas-Versorgungsflasche (7) durch die Spülgas-Ventilanordnung hindurch zu erlauben, und einer Öffnungsstellung, in welcher Fluiddurchlässe offen sind, um den Durchstrom von hochreinem Prozeßgas und einen Durchstrom von Spülgas aus einer Spülgasversorgungsleitung zu erlauben;
(b) einer Druckregeleinrichtung (2) mit Strömungsdurchlässen für einen Durchstrom von Gas von der Spülgas-Ventilanordnung (1), wobei der Druck des hindurchströmenden Gases mittels der Druckregeleinrichtung regelbar ist;
(c) einer Entlüftungsventilanordnung (3), die nur an der Niederdruckseite der Druckregeleinrichtung (2) angeordnet ist und zwischen einer Schließstellung, in welcher Fluiddurchlässe offen sind, um einen Durchstrom von hochreinem Prozeßgas oder Spülgas von der Druckregeleinrichtung zu erlauben, und einer Öffnungsstellung, in welcher Fluiddurchlässe offen sind, um den Durchstrom von Prozeßgas oder Spülgas und einen davon abgetrennten Durchstrom dieses Gases zwecks Entlüftung zu erlauben, umschaltbar ist; und
(d) einer Prozeßstrom-Ventilanordnung (5) zum Umschalten zwischen einer Öffnungsstellung, in welcher Fluiddurchlässe offen sind, um den Durchstrom von hochreinem Prozeßgas oder Spülgas zur Zufuhr zu einer Verwendungsstelle zu erlauben, und einer Schließstellung, in welcher der Gasstrom unterbrochen ist.

2. Gaszufuhrkonsole nach Anspruch 1, wobei die Fluiddurchlässe der Ventilanordnungen (1,3) zu beiden Seiten der Druckregeleinrichtung (2) im wesentlichen in der selben Ebene ausgerichtet sind, um einen geradlinigen Gasdurchstrom zu gewährleisten.

3. Gaszufuhrkonsole nach Anspruch 1, wobei die Spülgas-Ventilanordnung (1) in der Schließstellung offene Fluiddurchlässe an der Sechs-Uhr- und an der Neun-Uhr-Position aufweist, um den Durchstrom von Prozeßgas zu erlauben, und in der Öffnungsstellung offene Fluiddurchlässe an der Sechs-Uhr-, Neun-Uhr- und Zwölf-Uhr-Position aufweist, um den Durchstrom von Spülgas zu erlauben.

4. Gaszufuhrkonsole nach Anspruch 1, wobei auf der Druckregeleinrichtung (2) ein Hochdruck-Meßwertaufnehmer (11) und ein Niederdruck-Meßwertaufnehmer (12) angeordnet sind.

5. Gaszufuhrkonsole nach Anspruch 4, wobei der Hochdruck-Meßwertaufnehmer (11) an der Fünf-Uhr-Position angeordnet ist und der Niederdruck-Meßwertaufnehmer (12) an der Sieben-Uhr-Position angeordnet ist.

6. Gaszufuhrkonsole nach Anspruch 1, wobei die Entlüftungsventilanordnung (3) in der Schließstellung offene Fluiddurchlässe an der Drei-Uhr- und an der Neun-Uhr-Position aufweist, um den Durchstrom von Prozeßgas oder Spülgas zu einer Prüfventilanordnung (4) zu erlauben, und in der Öffnungsstellung offene Fluiddurchlässe an der Drei-Uhr-, Neun-Uhr- und Zwölf-Uhr-Position aufweist, um außerdem einen Durchstrom von Prozeßgas oder Spülgas zwecks Entlüftung zu erlauben.

7. Gaszufuhrkonsole nach Anspruch 1, wobei die Prozeßstrom-Ventilanordnung (5) in der Öffnungsstellung offene Fluiddurchlässe aufweist, um den Durchstrom von Prozeßgas oder Spülgas zu der Verwendungsstelle zu erlauben und um in der Schließstellung einen solchen Gasstrom zu der Verwendungsstelle zu unterbrechen.

8. Gaszufuhrkonsole nach Anspruch 1, wobei eine Vakuumerzeugungseinrichtung (6) zur Erzeugung eines Vakuums vorgesehen ist, um die Evakuierung von Gas zu erleichtern, welches von der Entlüftungs-Ventilanordnung (3) kommt, wenn sich die Entlüftungs-Ventilanordnung zwecks Entlüftung in einer Öffnungsstellung befindet.

9. Gaszufuhrkonsole nach Anspruch 8, wobei die Vakuumerzeugungseinrichtung (6) einen Auslaß und eine Anordnung für die Zuführung von inertem Gas zur Erzeugung von einem Druck unterhalb von Atmosphärendruck aufweist und ein Lüftungsaufsatzsystem zur Niederdruckentlüftung von Vakuumgas und von aus der Entlüftungsventilanordnung evakuiertem Gas einschließt.

10. Gaszufuhrkonsole nach einem der vorhergehenden Ansprüche, wobei eine Leitungsanordnung (8) vorgesehen ist, um eine Fluidverbindung zwischen der Spülgas-Ventilanordnung (1) und einer Prozeßgasflasche (7) herzustellen.

11. Gaszufuhrkonsole nach Anspruch 10, wobei eine Leitungsanordnung (20) vorgesehen ist, um eine Fluidverbindung zwischen der Prozeßstrom-Ventilanordnung (5) und der Verwendungsstelle herzustellen.

12. Gaszufuhrkonsole nach einem der vorhergehenden Ansprüche, wobei ein einstückiger Werkstoffblock vorgesehen ist, um die Spülgas-Ventilanordnung (1), die Druckregeleinrichtung (2), die Entlüftungs-Ventilanordnung (3) und die Prozeß-Ventilanordnung (5) aufzunehmen und um Fluiddurchlässe zur Verbindung der Ventilanordnungen und der Druckregeleinrichtung zu schaffen.

13. Gaszufuhrkonsole nach Anspruch 12, wobei der einstückige Block, die Ventilanordnungen und die Druckregeleinrichtung (1 bis 5) miniaturisiert sind, um die Gasstromwege weiter zu vereinfachen, die Leckgefahr zu verringern und für eine Niederdruckentlüftung zu sorgen, was die Verläßlichkeit und die Sicherheit der Gaszufuhrkonsole weiter verbessert.

14. Gaszufuhrkonsole nach einem der vorhergehenden Ansprüche mit einer Prüfventilanordnung (4) zum Umschalten zwischen einer Schließstellung, in welcher Fluiddurchlässe offen sind, um den Durchstrom von Prozeßgas oder Spülgas zu der Prozeßstrom-Ventilanordnung (5) zu erlauben, und einer Öffnungsstellung, in welcher außerdem Gas zu einer Gasversorgungsanordnung oder einer Aufnahmeeinrichtung außerhalb der Konsole geleitet oder aus dieser entnommen werden kann.

15. Gaszufuhrkonsole nach Anspruch 14, wobei die Prüfventilanordnung (4) in der Schließstellung offene Fluiddurchlässe an der Drei-Uhr- und an der Zwölf-Uhr-Position aufweist, um den Durchstrom von Prozeßgas oder Spülgas zu der Prozeß-Ventilanordnung zu erlauben, und in der Öffnungsstellung außerdem einen offenen Fluiddurchlaß an der Sechs-Uhr-Position aufweist, um die getrennte Überleitung von Gas zu oder von der Konsole zu erlauben.

16. Gaszufuhrkonsole nach Anspruch 14 oder 15, wobei die Prüfventilanordnung (4) so angeordnet ist, daß deren Fluiddurchlässe und die Fluiddurchlässe der anderen Ventilanordnungen zu beiden Seiten der Druckregeleinrichtung im wesentlichen in der selben Ebene ausgerichtet sind, um einen geradlinigen Gasdurchstrom zu gewährleisten.

17. Gaszufuhrkonsole nach einem der Ansprüche 12 bis 16, wobei die Fluiddurchlässe der Ventilanordnungen (1, 3) zu beiden Seiten der Druckregeleinrichtung (2) im wesentlichen in der selben Ebene ausgerichtet sind, um einen geradlinigen Gasdurchstrom zu gewährleisten.

18. Gaszufuhrkonsole nach einem der Ansprüche 12 bis 17, wobei der einstückige Werkstoffblock ein Metallblock ist.

19. Gaszufuhrkonsole nach Anspruch 18, wobei der einstückige Block ein Block aus rostfreiem Stahl ist.

## Revendications

1. Tableau de distribution de gaz pour distribuer un gaz de traitement à haute pureté d'une bouteille (7) d'alimentation à un poste d'outil, comportant :
(a) un moyen (1) à valve à gaz de purge conçu pour fonctionner entre une position fermée dans laquelle les orifices de passage de fluide sont ouverts pour le passage d'un gaz de traitement de haute pureté provenant d'une bouteille (7) d'alimentation en gaz de traitement à travers ledit moyen à valve à gaz de purge et une position ouverte dans laquelle des orifices de passage de fluide sont ouverts pour ledit passage de gaz de traitement de haute pureté à travers eux et pour le passage à travers eux d'un gaz de purge provenant d'une conduite d'alimentation en gaz de purge ;
(b) un moyen (2) à régulateur de pression ayant des orifices de passage d'écoulement pour le passage à travers eux d'un gaz provenant dudit moyen (1) à valve à gaz de purge, ledit moyen à régulateur de pression étant conçu pour réguler la pression de gaz passant à travers lui ;
(c) un moyen (3) à valve de mise à l'air positionné uniquement sur le côté basse pression dudit moyen (2) à régulateur de pression et conçu pour fonctionner entre une position fermée dans laquelle des orifices de passage de fluide sont ouverts pour le passage de gaz de traitement de haute pureté ou de gaz de purge provenant dudit moyen à régulateur de pression, et une position ouverte dans laquelle des orifices de passage de fluide sont ouverts pour ledit passage de gaz de traitement ou de gaz de purge, et pour le passage séparé dudit gaz qui en provient pour la mise à l'air ; et
(d) un moyen (5) à valve d'écoulement de traitement conçu pour fonctionner entre une position ouverte dans laquelle des orifices de passage de fluide sont ouverts pour le passage de gaz de traitement de haute pureté ou de gaz de purge à travers eux pour une distribution à un poste d'outil, et une position fermée faisant cesser ledit passage de gaz.

2. Tableau de distribution de gaz selon la revendication 1, dans lequel les orifices de passage de fluide desdits moyens à valves (1, 3) situés sur les deux cotés dudit moyen (2) à régulateur de pression sont alignés essentiellement dans le même plan pour établir un écoulement rectiligne du gaz passant dans ces orifices.

3. Tableau de distribution de gaz selon la revendication 1, dans lequel ledit moyen (1) à valve à gaz de purge, dans sa position fermée, présente des orifices ouverts de passage de fluide dans les positions 6 heures et 9 heures pour le passage à travers eux de gaz de traitement et, dans sa position ouverte, présente des orifices ouverts de passage de fluide dans les positions 6 heures, 9 heures et 12 heures pour le passage à travers eux de gaz de purge.

4. Tableau de distribution de gaz selon la revendication 1, dans lequel un moyen (11) à transducteur de haute pression et un moyen (12) à transducteur de basse pression sont positionnés sur ledit moyen (2) à régulateur de pression.

5. Tableau de distribution de gaz selon la revendication 4, dans lequel ledit moyen (11) à transducteur de haute pression est placé dans la position 5 heures et ledit moyen (12) à transducteur de basse pression est placé dans la position 7 heures.

6. Tableau de distribution de gaz selon la revendication 1, dans lequel ledit moyen (3) à valve de mise à l'air, dans sa position fermée, présente des orifices ouverts de passage de fluide dans les positions 3 heures et 9 heures pour le passage de gaz de traitement ou de gaz de purge à travers eux vers un moyen (4) à valve d'essai, et, dans sa position ouverte, présente des orifices ouverts de passage de fluide dans les positions 3 heures, 9 heures et 12 heures pour le passage de gaz de traitement ou de gaz de purge également pour la mise à l'air.

7. Tableau de distribution de gaz selon la revendication 1, dans lequel ledit moyen (5) à valve d'écoulement de traitement, dans sa position ouverte, présente des orifices ouverts de passage de fluide pour le passage de gaz de traitement ou de gaz de purge vers le poste d'outil et, dans sa position fermée, est conçu pour empêcher ce passage de gaz vers le poste d'outil.

8. Tableau de distribution de gaz selon la revendication 1, comprenant un moyen (6) à générateur de dépression conçu pour la génération d'une dépression afin de faciliter l'évacuation de gaz provenant dudit moyen (3) à valve de mise à l'air lorsque ledit moyen à valve de mise à l'air est dans une position ouverte pour une mise à l'air.

9. Tableau de distribution de gaz selon la revendication 8, dans lequel ledit moyen (6) à générateur de dépression comporte un éjecteur, et un moyen pour son alimentation en gaz inerte pour la génération d'une pression inférieure à celle de l'atmosphère, et comprenant un dispositif de mise à l'air pour la mise à l'air à basse pression de gaz en dépression et de gaz évacué dudit moyen à valve de mise à l'air.

10. Tableau de distribution de gaz selon l'une quelconque des revendications précédentes et comprenant un moyen à conduit (8) destiné à établir une communication de fluide entre ledit moyen (1) à valve à gaz de purge et une bouteille (7) de gaz de traitement.

11. Tableau de distribution de gaz selon la revendication 10 et comprenant un moyen à conduit (20) pour établir une communication de fluide entre ledit moyen (5) à valve d'écoulement de traitement et ledit poste d'outil.

12. Tableau de distribution de gaz selon l'une quelconque des revendications précédentes et comprenant un bloc d'une seule pièce de matière conçu pour l'insertion dudit moyen (1) à valve à gaz de purge, dudit moyen (2) régulateur de pression, dudit moyen (3) à valve de mise à l'air et dudit moyen (5) à valve de traitement, ledit bloc d'une seule pièce étant conçue pour présenter des orifices de passage de fluide pour le raccordement entre eux, dans le bloc, desdits moyens à valves et à régulateur de pression.

13. Tableau de distribution de gaz selon la revendication 12, dans lequel ledit bloc d'une seule pièce et lesdits moyens à valves et régulateur de pression (1 à 5) sont miniaturisés pour simplifier davantage les trajets d'écoulement de gaz, réduire le risque de fuite et établir une mise à l'air à basse pression, renforçant ainsi davantage la fiabilité et la sécurité du système du tableau de gaz.

14. Tableau de distribution de gaz selon l'une quelconque des revendications précédentes et comprenant un moyen (4) à valve d'essai conçu pour fonctionner entre une position fermée dans laquelle des orifices de passage de fluide sont ouverts pour le passage de gaz de traitement ou de gaz de purge vers ledit moyen (5) à valve d'écoulement de traitement, et une position ouverture dans laquelle du gaz peut également s'écouler vers ou provenir d'un moyen d'alimentation ou de réception de gaz à l'extérieur dudit panneau.

15. Tableau de distribution de gaz selon la revendication 14, dans lequel ledit moyen (4) à valve d'essai, dans sa position fermée, présente des orifices ouverts de passage de fluide dans les positions 3 heures et 12 heures pour le passage de gaz de traitement ou de gaz de purge vers ledit moyen à valve de traitement, et dans sa position ouverte, présente aussi un orifice ouvert de passage de fluide dans la position 6 heures pour le passage séparé de gaz vers ledit tableau ou en provenance de celui-ci.

16. Tableau de distribution de gaz selon la revendication 14 ou 15, dans lequel ledit moyen (4) à valve d'essai est positionné de façon que ses orifices de passage de fluide et que les orifices de passage de fluide des autres moyens à valves sur les deux côtés dudit moyen à régulateur de pression, soient alignés essentiellement dans le même plan pour établir un écoulement rectiligne du gaz passant dans ces orifices.

17. Tableau de distribution de gaz selon l'une quelconque des revendications 12 à 16, dans lequel les orifices de passage de fluide desdits moyens à valves (1, 3) sur les deux côtés dudit moyen (2) à régulateur de pression sont alignés essentiellement dans le même plan pour établir un écoulement rectiligne du gaz passant dans ces orifices.

18. Tableau de distribution de gaz selon l'une quelconque des revendications 12 à 17, dans lequel ledit bloc d'une seule pièce de matière comprend un bloc métallique.

19. Tableau de distribution de gaz selon la revendication 18, dans lequel ledit bloc d'une seule pièce comprend un bloc d'acier inoxydable.
